(19) Europäisches Patentamt
European Patent Office
Office européen des brevets

(11) EP 4 796 316 A1

# (12) EUROPEAN PATENT APPLICATION

published in accordance with Art. 153(4) EPC

(43) Date of publication:
**26.08.2026 Bulletin 2026/35**

(21) Application number: **24879826.6**

(22) Date of filing: **18.10.2024**

(51) International Patent Classification (IPC):
***B32B 9/00*** *(2006.01)* ***C23C 14/10*** *(2006.01)*
***C23C 14/24*** *(2006.01)*

(52) Cooperative Patent Classification (CPC):
**B32B 9/00; C23C 14/10; C23C 14/24**

(86) International application number:
**PCT/JP2024/037206**

(87) International publication number:
**WO 2025/084406 (24.04.2025 Gazette 2025/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.10.2023 JP 2023180257**

(71) Applicant: **Toppan Holdings Inc.**
**Tokyo 110-0016 (JP)**

(72) Inventors:
- **KUWAGATA Yusuke**
  **Tokyo 110-0016 (JP)**
- **MATSUHISA Kenji**
  **Tokyo 110-0016 (JP)**
- **TANI Takayuki**
  **Tokyo 110-0016 (JP)**

(74) Representative: **Hoffmann Eitle**
**Patent- und Rechtsanwälte PartmbB**
**Arabellastraße 30**
**81925 München (DE)**

## (54) GAS BARRIER FILM AND MANUFACTURING METHOD

(57) This disclosure provides a gas barrier film including a substrate layer; and a gas barrier layer formed on the substrate layer and containing silicon oxide, wherein in an infrared absorption spectrum from a surface side of the gas barrier layer, the ratio of the peak area of the absorption peak at 3,100 $cm^{-1}$ or more and 3,700 $cm^{-1}$ or less derived from the OH bond to the peak area of the absorption peak at 720 $cm^{-1}$ or more and 1,320 $cm^{-1}$ or less derived from the Si-O-Si bond is 0.25 or less.

FIG.1

1
20
10

EP 4 796 316 A1

## Description

[Technical Field]

The present invention relates to gas barrier films, and more specifically relates to gas barrier films suitable for packaging food, pharmaceuticals, precision electronic components, etc. Production methods for such gas barrier films are also discussed.

The present application claims the benefit of priority from Japanese Patent Application No. 2023-180257 filed in Japan on October 19, 2023, the contents of which are incorporated herein by reference.

[Background Art]

From the perspective of suppressing deterioration of the contents and retaining the functions and nature of the contents, packaging materials used for food or pharmaceuticals may be required to have gas barrier properties for blocking oxygen, water vapor, and other gases that pass through the packaging materials and deteriorate the contents. Known packaging materials having gas barrier properties include gas barrier films in which a metal foil such as an aluminum foil, which is less affected by temperature, humidity, and the like, is used as a gas barrier layer.

Another configuration of gas barrier films is known in which a vapor deposition film made of an inorganic oxide such as silicon oxide or aluminum oxide is formed by vacuum deposition, sputtering, or the like on a substrate film made of a polymer material (e.g., see PTL 1). These gas barrier films are transparent and have gas barrier properties against oxygen, water vapor, etc.

[Citation List]

[Patent Literature]

PTL 1: JPS60-049934A

[Summary of the Invention]

[Technical Problem]

The present inventors have found that when a gas barrier layer is formed of a silicon oxide vapor deposition film, variation in water vapor barrier properties tends to be comparatively large. The present invention has been obtained as a result of the inventors' diligent studies for suppressing this tendency.

In light of the circumstances described above, the present invention aims to provide a gas barrier film with stable water vapor barrier properties, while including a gas barrier layer containing silicon oxide.

[Solution to Problems]

[1] A first aspect of the present invention is a gas barrier film including a substrate layer and a gas barrier layer formed on the substrate layer and containing silicon oxide.

In an infrared absorption spectrum from the surface side of the gas barrier layer, the ratio of the peak area of the absorption peak at 3,100 $cm^{-1}$ or more and 3,700 $cm^{-1}$ or less derived from an OH bond to the peak area of the absorption peak at 720 $cm^{-1}$ or more and 1,320 $cm^{-1}$ or less derived from an Si-O-Si bond is 0.25 or less.

[2] The gas barrier film according to [1], wherein In an infrared absorption spectrum from the surface side of the gas barrier layer, the ratio of the peak area of the absorption peak at 830 $cm^{-1}$ or more and 910 $cm^{-1}$ or less derived from an Si-OH bond to the peak area of the absorption peak at 720 $cm^{-1}$ or more and 1,320 $cm^{-1}$ or less derived from an Si-O-Si bond is 0.025 or less.

[3] The gas barrier film according to [1] or[2], wherein in an infrared absorption spectrum from the surface side of the gas barrier layer, the ratio of the peak area of the absorption peak at 2,100 $cm^{-1}$ or more and 2,200 $cm^{-1}$ or less derived from an Si-H bond to the peak area of the absorption peak at 720 $cm^{-1}$ or more and 1,320 $cm^{-1}$ or less derived from an Si-O-Si bond is 0.003 or less.

[4] The gas barrier film according to any one of [1] to [3], wherein a ratio b/a of peaks of a sum of $Si^{3+}$, $Si^{2+}$, $Si^{+}$ and Si (b = $Si^{3+}$, $Si^{2+}$, $Si^{+}$ and Si) to a sum of all of peaks in an $Si_{2p}$ peak (a= $Si^{4+}$, $Si^{3+}$, $Si^{2+}$, $Si^{+}$ and Si) on the surface of the gas barrier layer as measured by X-ray photoelectron spectroscopy (XPS) is greater than 0.122.

[5] The gas barrier film according to any one of [1] to [4], wherein a ratio O/Si between the number of oxygen (O) atoms and the number of silicon (Si) atoms on the surface of the gas barrier layer as measured by X-ray photoelectron spectroscopy (XPS) is 1.41 or more and 1.9 or less.
[6] The gas barrier film according to any one of [1] to [5], wherein the gas barrier layer has a thickness of 10 nm or more and 60 nm or less.
[7] The gas barrier film according to any one of [1] to [6], further including
an overcoat layer formed on the gas barrier layer.
[8] The gas barrier film according to [7], wherein the overcoat layer contains a water-soluble polymer and at least one of a metal alkoxide, a hydrolysate of a metal alkoxide, a reaction product of a metal alkoxide, and a reaction product of a hydrolysate of a metal alkoxide.
[9] The gas barrier film according to [7] or [8], wherein the overcoat layer contains at least one of a silane coupling agent, a hydrolysate of a silane coupling agent, a reaction product of a silane coupling agent, and a reaction product of a hydrolysate of a silane coupling agent.
[10] The gas barrier film according to any one of [1] to [9], further comprising an undercoat layer provided between the substrate layer and the gas barrier layer, wherein the undercoat layer contains at least one of a thermosetting resin, a thermoplastic resin, a UV curable resin, and an electron beam curable resin.
[11] The gas barrier film according to any one of [1] to [10], further including an undercoat layer provided between the substrate layer and the gas barrier layer, wherein the undercoat layer is made of a cured product of a composition containing an acrylic polyol resin having an organic acid group and a polyisocyanate.

A second aspect of the present invention is a production method for the gas barrier film according to the first aspect.

**In** the production method, a deposition device is set that includes a deposition chamber and an unwinding/winding chamber with a gas adsorption device (device for condensing and adsorbing gas (water vapor)) provided in each of the deposition chamber and the unwinding/winding chamber; a substrate layer in a roll shape is attached to an unwinding roll disposed in the unwinding/winding chamber; and a gas barrier layer is formed on the substrate layer passing through the deposition chamber under conditions in which a partial pressure at m/z 18 in the deposition chamber is set to 0.05 Pa or less by operating the gas adsorption devices in the deposition chamber and the unwinding/winding chamber, the gas barrier layer being made of a deposition material obtained by mixing an Si material and an $SiO_2$ material.

[Advantageous Effects of the Invention]

According to the present invention, a gas barrier film can be provided which has stable water vapor barrier properties, while including a gas barrier layer containing silicon oxide.

[Brief Description of the Drawings]

Fig. 1 is a schematic cross-sectional view illustrating a gas barrier film according to a first embodiment of the present invention.
Fig. 2 is a schematic diagram illustrating an example of a device for producing the gas barrier film.
Fig. 3 is a schematic cross-sectional view illustrating a gas barrier film according to a second embodiment of the present invention.
Fig. 4 is a schematic cross-sectional view illustrating a modification of the gas barrier film.

[Description of the Embodiments]

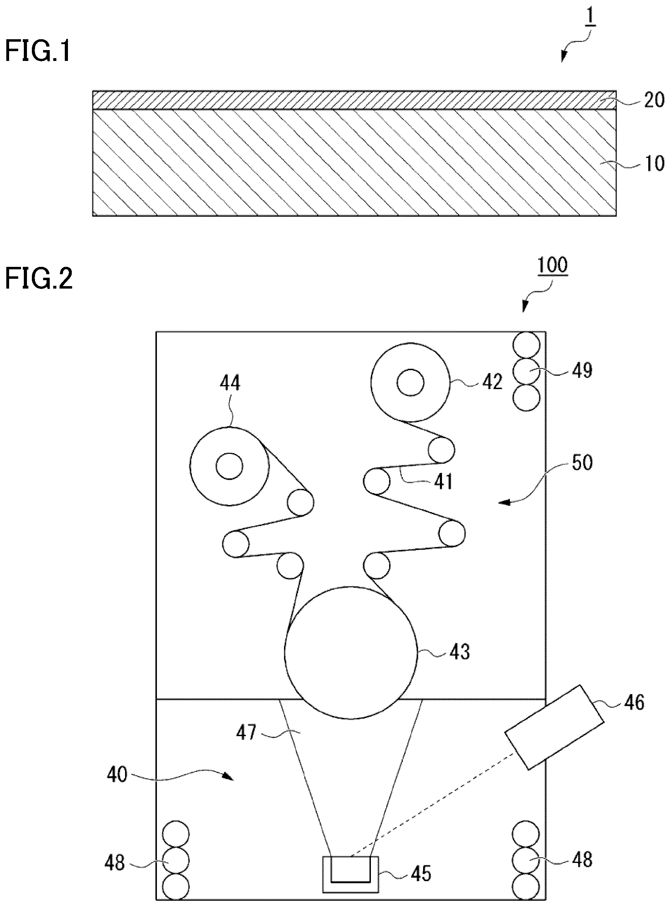

Referring to Fig. 1, a first embodiment of the present invention will be described.

Fig. 1 is a schematic cross-sectional view illustrating a gas barrier film 1 according to the present embodiment. The gas barrier film 1 includes a substrate layer 10 and a gas barrier layer 20 provided to one surface of the substrate layer 10.

The substrate layer 10 is made of a synthetic resin. There is no specific limitation to the materials of the substrate layer 10 and known various materials can be used. Specific examples include polyolefin resins (polyethylene, polypropylene, etc.), polyester resins (polyethylene terephthalate, polyethylene naphthalate, etc.), polyimide resins, polyamide resins (nylon-6, nylon-66, etc.), polystyrene, ethylene vinyl alcohol, polyvinyl chloride, polyimide, polyvinyl alcohol, polycarbonate, polyethersulfone, acrylic resins, cellulose resins (triacetyl cellulose, diacetyl cellulose, etc.). Practically, materials are preferably appropriately selected depending on applications and required physical properties. For packages

protecting contents that are extremely sensitive to moisture, such as electronic and optical components, it is preferable to use materials, such as polyethylene naphthalate, polyimides, and polyethersulfone, having high gas barrier properties themselves. For packaging material applications, it is preferable to use polyethylene terephthalate, polyethylene, and polypropylene.

When used as packaging materials in particular, the substrate layer 10 preferably has flexibility and rigidity for enduring processing, and thus the thickness is preferably around 9 μm to 100 μm. More preferably, the thickness is 9 μm to 90 μm, 9 μm to 70 μm, 9 μm to 50 μm, or 9 μm to 30 μm. The substrate layer 10, when having a thickness of this range, will have suitable flexibility and can be wound up in a roll, and therefore can be easily handled.

The material of the substrate layer 10 may be provided in a continuous form or in the form of sheets; however, the continuous form is preferably used. The longitudinal length of the substrate layer 10 in a continuous form is not particularly limited but a resin film with a length of 10 m or more is preferably used. The upper limit of the length is not limited but may be, for example, around 10 km.

The surface of the substrate layer 10 may contain additives as necessary such as antistatic agents, UV absorbers, plasticizers, and lubricants. In order to enhance adhesion, the surface of the substrate layer 10 may undergo physical treatment such as corona treatment, flame treatment, plasma treatment, or adhesion enhancing treatment, or chemical treatment and modification with chemical solutions such as acid or alkali. The surface of the substrate layer 10 contributes to providing denseness in the initial growth stage of vacuum deposition when forming a gas barrier layer, and is preferably smooth as much as possible from this perspective.

The gas barrier layer 20 has a main function of providing gas barrier properties exhibited by the gas barrier film 1 and is formed of an inorganic oxide film containing at least silicon oxide (SiOx).

In the gas barrier layer 20 according to the present embodiment, the ratio between the number of oxygen (O) atoms and the number of silicon (Si) atoms (O/Si) is 1.0 or more and 1.9 or less at least on the surface of the gas barrier layer 20. Considering transparency of the gas barrier film 1 as a whole, O/Si is more preferably 1.3 or more. From the perspective of satisfying both barrier properties and transparency, O/Si may be preferably 1.3 or more and 1.9 or less, and more preferably 1.4 or more and 1.9 or less, 1.41 or more and 1.9 or less, 1.45 or more and 1.9 or less, 1.5 or more and 1.9 or less, 1.6 or more and 1.9 or less, or 1.7 or more and 1.9 or less, or may be 1.41 or more and 1.85 or less, 1.41 or more and 1.8 or less, 1.45 or more and 1.85 or less, or 1.45 or more and 1.8 or less.

O/Si of the gas barrier layer 20 can be evaluated using an analytical instrument such as an X-ray photoelectron spectrometer (XPS). The analytical instrument such as an X-ray photoelectron spectrometer (XPS) may use argon (Ar) ion sputtering etching to analyze inside the film; however, the transparent oxide film layer containing silicon (Si) is reduced and it is difficult to obtain a correct ratio (O/Si) between the number of silicon (Si) atoms and the number of oxygen (O) atoms, and therefore it is desirable to analyze the surface of the layer.

The method of forming the gas barrier layer 20 is not limited.
For example, known deposition methods such as vacuum vapor deposition, ion plating, sputtering, and plasma-enhanced chemical vapor deposition (PECVD) can be used; however, vacuum vapor deposition is particularly preferable because of having high productivity. The material heating method that can be used in the vacuum vapor deposition may be resistance heating, high frequency induction heating, electron beam heating, etc. These methods can be combined with a plasma assisted method, ion assisted method, or the like to form a gas barrier layer 20 with high density and to thereby enhance barrier properties.

When forming the gas barrier layer 20 using vacuum vapor deposition, the partial pressure at m/z 18 measured with a partial pressure meter (quadrupole mass spectrometer using a Faraday cup) during deposition is set to 0.05 Pa or less. If the partial pressure at m/z 18 measured using a mass spectrometer during deposition exceeds 0.09 Pa, the amount of OH in the inorganic oxide film undesirably increases and the amount of OH or H bonded to Si undesirably increases due to the large amount of water molecules in the deposition atmosphere.
m/z (italics to be exact) is a value defined to be a dimensionless quantity which is obtained by dividing the mass of ions by the unified atomic mass unit, and then dividing the obtained dimensionless quantity by the absolute value of the number of charges of the ions, and is the value used on the horizontal axis of a mass spectrum measured by the mass spectrometer. m/z is defined as a scientific term by the International Union of Pure and Applied Chemistry (IUPAC). m/z 18 is the m/z derived from the $H_2O^+$ ions associated with water. The ions associated with water include fragment ions at m/z 17, etc. other than m/z 18; however, m/z 18 derived from $H_2O^+$ ions having the strongest spectral intensity is used as an index in the present invention.

In a typical and specific method of adjusting the partial pressure at m/z 18 during deposition, a mechanism of adsorbing gas is provided in the deposition environment. For example, a device for condensing and adsorbing gas (water vapor) (hereinafter referred to as gas adsorption device) may be provided in the deposition chamber of the deposition device to achieve the effect of reducing water vapor in the deposition chamber. Thus, the partial pressure at m/z 18 during deposition can be suppressed to 0.05 Pa or less. Another gas adsorption device may be provided inside the unwinding/winding chamber, particularly near the unwinding roll, to achieve the effect of reducing water vapor derived from the moisture released from the substrate. The moisture released from the substrate may hinder the initial film growth of the gas

barrier layer. By controlling the water vapor derived from the moisture released from the substrate, a dense gas barrier layer can be formed during the initial film growth, thereby achieving stable water vapor barrier properties throughout the gas barrier layer, as well as the water vapor barrier properties for the initially formed film.

As the gas adsorption device, a Meissner coil, cryopanel, cryopump, sorption pump, ion pump, or getter pump is preferably used, and more preferably a Meissner coil or cryopanel is used because the adsorption area can be increased. For example, when using a Meissner coil or cryopanel, the cooling temperature may be preferably -100°C or less, and may be more preferably -110°C or less, from the perspective of achieving sufficient gas condensing and adsorbing performance.

The present inventors have found that when the O/Si value mentioned above and the partial pressure at m/z 18 during deposition are adjusted to a predetermined range, the intermolecular gaps in the inorganic oxide film as formed are reduced compared to films obtained through ordinary deposition processes. In such an inorganic oxide film, there is less room for adsorbed water to enter, and the amount of OH in the inorganic oxide film is reduced. Furthermore, since the number of dangling bonds is reduced, the amount of OH or H that can bond with Si is also reduced, and therefore using such a film as the gas barrier layer 20, stability can be enhanced in the exhibited water vapor barrier properties.

The state of the gas barrier layer 20 described above can be evaluated by calculating the amounts of OH, Si-OH, Si-H, etc. using Fourier transform infrared spectrophotometer (FT-IR) analysis.

Specifically, in the infrared absorption spectrum obtained by FT-IR analysis, using software attached to the device, a baseline connecting the plots at both ends of a defined range is drawn for each of the peak area derived from the Si-O-Si bond (720 $cm^{-1}$ to 1,320 $cm^{-1}$), the peak area derived from the OH bond (3,100 $cm^{-1}$ to 3,700 $cm^{-1}$), the peak area derived from the Si-OH bond (830 $cm^{-1}$ to 910 $cm^{-1}$), and the peak area derived from the Si-H bond (2,100 $cm^{-1}$ to 2,200 $cm^{-1}$), and the area enclosed by the spectrum and the baseline is calculated. In this case, the region below the baseline is ignored and not included in the area. Measurements in the FT-IR analysis are often performed by the ATR method; however, the inventors' studies have revealed that data before corrections such as ATR correction and baseline correction more accurately reflect the properties of the gas barrier layer 20. Therefore, the parameters referred to below are defined be those of uncorrected data obtained by the FT-IR analysis.

Although the details will be shown through examples later, as a result of the inventors' studies, it was found that the following conditions could be independent criteria for the gas barrier layer 20 to have a smaller number of intermolecular gaps and to be dense as a film:

The ratio of the peak area derived from the OH bond (3,100 $cm^{-1}$ to 3,700 $cm^{-1}$) to the peak area derived from the Si-O-Si bond (720 $cm^{-1}$ to 1,320 $cm^{-1}$) is 0.25 or less;
The ratio of the peak area derived from the Si-OH bond (830 $cm^{-1}$ to 910 $cm^{-1}$) to the peak area derived from the Si-O-Si bond (720 $cm^{-1}$ to 1,320 $cm^{-1}$) is 0.025 or less; and
The ratio of the peak area derived from the Si-H bond (2,100 $cm^{-1}$ to 2,200 $cm^{-1}$) to the peak area derived from the Si-O-Si bond (720 $cm^{-1}$ to 1,320 $cm^{-1}$) is 0.003 or less.

The OH bond is an index correlated with the amount of adsorbed water in the gas barrier layer 20. As the ratio of the peak area derived from the OH bond (3,100 $cm^{-1}$ to 3,700 $cm^{-1}$) to the peak area derived from the Si-O-Si bond (720 $cm^{-1}$ to 1,320 $cm^{-1}$) is smaller, the amount of adsorbed water in the structure of the gas barrier layer 20 is considered to be smaller.

The Si-OH bond is an index correlated with the amount of adsorbed water and the amount of dangling bonds of Si in the gas barrier layer 20. As the ratio of the peak area derived from the Si-OH bond (830 $cm^{-1}$ to 910 $cm^{-1}$) to the peak area derived from the Si-O-Si bond (720 $cm^{-1}$ to 1,320 $cm^{-1}$) is smaller, the amount of adsorbed water and the amount of dangling bonds of Si in the structure of the gas barrier layer 20 are considered to be smaller.

The Si-H bond is an index correlated with the amount of dangling bonds of Si in the gas barrier layer 20. As the ratio of the peak area derived from the Si-H bond (2,100 $cm^{-1}$ to 2,200 $cm^{-1}$) to the peak area derived from the Si-O-Si bond (720 $cm^{-1}$ to 1,320 $cm^{-1}$) is smaller, the amount of dangling bonds of Si in the structure of the gas barrier layer 20 is considered to be smaller.

The three indices based on the OH bond, the Si-OH bond, and the Si-H bond all reflect the amount of defects in the Si-O-Si structure, and the size of defects reflected becomes smaller in the order of the OH bond, the Si-OH bond, and the Si-H bond. In order to reduce the peak areas derived from the OH bond, the Si-OH bond, and the Si-H in this order, the partial pressure at m/z 18 is required to be tightly controlled.

In particular, by reducing the peak areas derived from both the Si-OH bond and the Si-H bond, a dense gas barrier layer can be formed during the initial film growth, thereby achieving stable water vapor barrier properties throughout the gas barrier layer, as well as the water vapor barrier properties for the initially formed film.

The gas barrier film according to the present invention can exhibit stable gas barrier properties by including the gas barrier layer 20 satisfying at least one of the above criteria. Also, high and stable gas barrier properties can be achieved even in mass production processes, and high-quality gas barrier films can be efficiently produced.

The chemical bonding state of the gas barrier layer 20 can also be analyzed using X-ray photoelectron spectroscopy (hereinafter may also be referred to as XPS). XPS is a technique in which an object to be measured is irradiated with X-rays and the photoelectrons emitted from the surface of the object are analyzed in terms of energy. This technique can analyze the composition and chemical bonding state of elements in a region several nanometers deep from the surface of the object. It is known that, in the chemical bonding state of silicon oxide in an gas barrier layer 20, there are three suboxide components of $Si^{3+}$, $Si^{2+}$ and $Si^{+}$, and Si, other than $SiO_2(Si^{4+})$, five in all. When the narrow spectrum of $Si_{2p}$ is measured using XPS, $SiO_2$ is observed around 103.5 to 104.5 eV, and $Si^{3+}$, $Si^{2+}$, $Si^{+}$ and Si are observed at positions shifted to the lower energy side than $SiO_2$, each separated by approximately 1 eV.

When the narrow spectrum of $Si_{2p}$ is measured using XPS with the general-purpose X-ray source of Mg $K\alpha$ or Al $K\alpha$ and a pass energy of around 10 eV, the bond peaks are not separated and observed in a composite form. Therefore, in the narrow spectrum of $Si_{2p}$, the peak top is detected around 103.5 to 104.5 eV when the film is an $SiO_2$ film; however, when the film is a silicon oxide film containing mainly $SiO_2$ and other multiple chemical bonds, the peak tops are shifted to the range of 101 to 103.5 eV. Compared to the $SiO_2$ film, the silicon oxide film containing mainly $SiO_2$ and other multiple chemical bonds broadens the full width at half maximum (FWHM) of the $Si_{2p}$ peak. Since a peak shift occurs due to charging, it is necessary to correct it using the $C_{1s}$ peak detected due to surface-contaminating hydrocarbons. In the present invention, the $C_{1s}$ peak detected due to surface-contaminating hydrocarbons was assumed to be 284.6 eV. XPS may often use sputter etching using argon (Ar) ions for analysis in the depth direction. However, this may cause reduction, mixing, etc. due to collision between the argon (Ar) ions and may change the chemical bonds in the original silicon oxide film, and therefore it is preferable to use surface analysis without using sputter etching.

On the surface of the gas barrier layer 20 of the present embodiment, a ratio b/a value, i.e., a ratio of a sum of the peaks of $Si^{3+}$, $Si^{2+}$, $Si^{+}$ and Si (b = $Si^{3+}$, $Si^{2+}$, $Si^{+}$ and Si) to a sum of all of the peaks in the $Si_{2p}$ peak (a= $Si^{4+}$, $Si^{3+}$, $Si^{2+}$, $Si^{+}$ and Si) as measured by X-ray photoelectron spectroscopy (XPS) is preferably greater than 0.122. When the b/a value is greater than 0.122, a dense structure can be formed due to the film being a silicon oxide film containing multiple chemical bonds other than $SiO_2$, and therefore the number of gas molecule permeation pathways can be reduced. When the b/a value is 0.153 or less, sufficient transparency can be achieved. From the perspective of satisfying both barrier properties and transparency, b/a may be preferably 0.123 or more and 0.153 or less, and more preferably 0.123 or more and 0.148 or less, 0.123 or more and 0.147 or less, 0.123 or more and 0.145 or less, 0.123 or more and 0.143 or less, 0.123 or more and 0.138 or less, or 0.123 or more and 0.133 or less, or may be 0.126 or more and 0.147 or less, 0.128 or more and 0.147 or less, 0.128 or more and 0.145 or less, or 0.128 or more and 0.143 or less.

The gas barrier layer 20 of the present embodiment is preferably amorphous. A polycrystalline film may cause grain boundaries; however, a gas barrier layer 20 formed of an amorphous film will not cause grain boundaries and can reduce the number of gas molecule permeation pathways. Whether the gas barrier layer 20 is amorphous can be determined using a known method. For example, whether the gas barrier layer 20 is amorphous can be determined based on whether the layer has crystal diffraction peaks in an X-ray diffraction pattern obtained using an analytical instrument such as an X-ray diffraction device (XRD).

The thickness of the gas barrier layer 20 varies depending on the configuration and deposition method used; however, in general, the thickness can be set appropriately in the range of 1 nm to 200 nm. If the thickness of the gas barrier layer 20 is less than 1 nm, the film may not be uniform or may not have a sufficient thickness, and may not sufficiently exhibit functions as a gas barrier layer. If the thickness of the gas barrier layer 20 exceeds 200 nm, cracking may occur after deposition due to external factors such as bending and tension, resulting in loss of barrier properties. Preferably, the thickness is in the range of 5 nm to 150 nm, more preferably 10 nm to 120 nm, 10 nm to 60 nm, 10 nm to 50 nm, 10 nm to 45 nm, or 10 nm to 40 nm.

Fig. 2 is a schematic diagram illustrating an example of a device for producing a gas barrier film according to an embodiment of the present invention. For production, a deposition device 100 is used which includes a vacuum deposition chamber 40 and an unwinding/winding chamber 50 in which an unwinding roll 42 is disposed. The deposition chamber 40 and the unwinding/winding chamber 50 are defined by a partition wall and have respective independent exhaust systems. The deposition chamber 40 is installed with a gas adsorption device 48, and another gas adsorption device 49 having functions similar to those of the gas adsorption device 48 is installed in the vicinity of the unwinding roll 42 in the unwinding/winding chamber 50. The gas adsorption device 49 may be any device capable of condensing and adsorbing gas, and may be of a type that is the same as or different from the type of the gas adsorption device 48.

A plastic film 41 that will serve as the substrate layer 10 is set on the unwinding roll 42. The plastic film 41 unwound from the unwinding roll 42 passes through a deposition roll 43 exposed in the deposition chamber 40, and is then wound up onto a winding roll 44. Inside the deposition chamber 40, a deposition material 45 for depositing a gas barrier layer 20 is set, and an electron beam gun 46 as a deposition tool is installed. The deposition material 45 heated by the electron beams becomes vapor deposition particles 47 and is deposited on the plastic film. Thus, a gas barrier layer 20 is formed on the plastic film 41.

The deposition material 45 comprises a material obtained by mixing an Si material and an $SiO_2$ material. The Si material includes pure Si and/or a material containing Si elements excluding $SiO_2$. O/Si in the gas barrier layer can be

adjusted by appropriately adjusting the ratio between the Si material and the $SiO_2$ material.

Fig. 2 shows an electron beam deposition method using the electron beam gun 46 as a method of heating the deposition material 45; however, the deposition material 45 may be heated and evaporated using resistance heating, high frequency induction heating, or the like. The resistance heating may be a method in which a crucible filled with the material is directly resistance-heated, or may be another method. Whichever method may be used, the device used is required to have a configuration capable of achieving high deposition speed.

The device for producing a gas barrier layer deposition film is not limited to this form. As necessary, a plasma pre-treatment device may be installed in the unwinding/winding chamber, or a reaction gas introduction device may be installed in the deposition chamber. The disposition of the rolls is not particularly limited also.

In the present embodiment, the following modifications can be made.

The gas barrier layer may be provided to each of both surfaces of the substrate layer 10. In this case, the two gas barrier layers may be identical with or different from each other.

The substrate layer 10 may undergo plasma treatment and a gas barrier layer 20 may be laminated on the surface subjected to plasma treatment to enhance adhesion between the substrate layer 10 and the gas barrier layer 20 and gas barrier properties. Various known plasma treatments, such as reactive ion etching (RIE), corona treatment, hollow anode plasma treatment, and flat plate plasma treatment, can be adopted as a plasma treatment for the substrate layer 10, and other various known surface treatments, such as ozone treatment and ion beam treatment, can also be adopted as a treatment having the same effect as that of the plasma treatment. The gas species used in the plasma treatment may be any known discharge gas such as argon, oxygen, nitrogen, or helium.

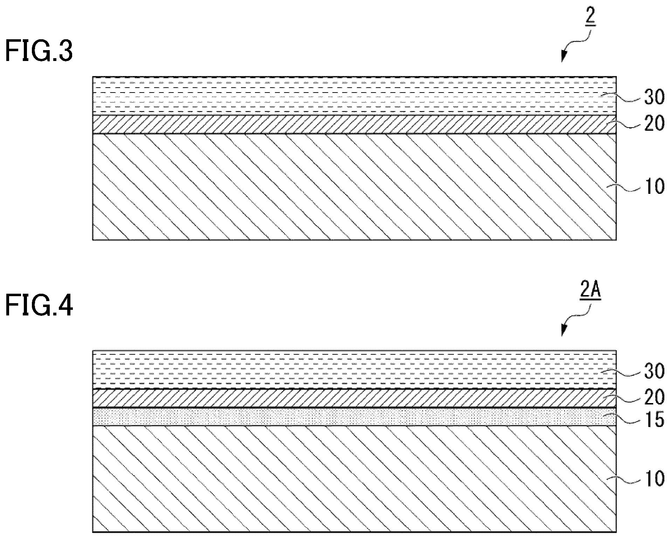

Referring to Fig. 3, a second embodiment of the present invention will be described. In the following description, the components common to those already described are designated with the same reference signs to omit repeated explanations.

Fig. 3 is a schematic cross-sectional view illustrating a gas barrier film 2 according to the present embodiment. The gas barrier film 2 further includes an overcoat layer 30 provided on the gas barrier layer 20.

The overcoat layer 30, which contains an organic polymer resin, protects the gas barrier layer 20 and prevents occurrence of cracking due to abrasion or bending.

Any known gas barrier film may be used as the overcoat layer 30. In this case, barrier properties can be further enhanced throughout the gas barrier film.

The overcoat layer 30 can be obtained, for example, by forming a coating of a coating agent on the gas barrier layer 20 using a wet coating method, and drying the coating. In the present specification, the term coating refers to a wet covering and the term film refers to a dry covering.

The overcoat layer 30 may be a film containing a metal alkoxide and a hydrolysate thereof, or at least one of reaction products thereof, and a water-soluble polymer (hereinafter may also be referred to as organic-inorganic composite film). The film preferably further contains a silane coupling agent and/or a hydrolysate thereof.

Examples of the metal alkoxide and a hydrolysate thereof contained in the organic-inorganic composite film include materials expressed by a general formula $M(OR)_n$, such as tetraethoxysilane $[Si(OC_2H_5)_4]$ and triisopropoxy aluminum $[Al(OC_3H_7)_3]$, and hydrolysates thereof. These materials may be used singly or in combination of two or more.

The total content of the metal alkoxide and a hydrolysate thereof or at least one of reaction products thereof in the organic-inorganic composite film may be 40 to 70 mass%, for example. From the perspective of further enhancing gas barrier properties, the lower limit of the total content of the metal alkoxide and a hydrolysate thereof or at least one of reaction products thereof in the organic-inorganic composite film can be 50 mass%. From the same perspective, the upper limit of the total content of the metal alkoxide and a hydrolysate thereof or at least one of reaction products thereof in the organic-inorganic composite film can be 65 mass%.

The water-soluble polymer contained in the organic-inorganic composite film is not particularly limited, and examples of which include polyvinyl alcohol-based polymers, acrylic polyol-based polymers and other polymers, and polysaccharides such as starch, methylcellulose, and carboxymethylcellulose. From the perspective of further improving gas barrier properties, the organic-inorganic composite film preferably contains a polyvinyl alcohol-based polymer. The number average molecular weight of the water-soluble polymer may, for example, be 40,000 to 180,000.

The polyvinyl alcohol-based water-soluble polymer can be obtained, for example, by saponification (including partial saponification) of a polyvinyl acetate. In this water-soluble polymer, several tens percent of acetic acid groups may remain, or only several percent of acetic acid groups may remain.

The water-soluble polymer content in the organic-inorganic composite film may be, for example, 15 to 50 mass%. It is preferable that the water-soluble polymer content is 20 to 45 mass% because gas barrier properties of the organic-inorganic composite film can be further enhanced.

The silane coupling agent and a hydrolysate thereof contained in the organic-inorganic composite film may be a silane coupling agent having an organic functional group. The silane coupling agent and a hydrolysate thereof may be ethyltrimethoxysilane, vinyltrimethoxysilane, γ-chloropropylmethyldimethoxysilane, γ-chloropropyltrimethoxysilane, glycidoxypropyltrimethoxysilane, γ-methacryloxypropyltrimethoxysilane, γ-methacryloxypropylmethyl dimethoxysilane, and

hydrolysates thereof. These materials may be used singly or in combination of two or more.

At least one of the silane coupling agent and a hydrolysate thereof preferably contains an epoxy group as an organic functional group. Examples of the silane coupling agent having an epoxy group include γ-glycidoxypropyltrimethoxysilane and β-(3,4-epoxycyclohexyl) ethyltrimethoxysilane. The silane coupling agent having an epoxy group and a hydrolysate thereof may contain an organic functional group, such as a vinyl group, amino group, methacrylic group, or ureido group, different from the epoxy group.

The silane coupling agent having an organic functional group and a hydrolysate thereof can further enhance barrier properties of the overcoat layer 30 and adhesion to the gas barrier layer 20 by interaction between the organic functional group and the hydroxyl group of the water-soluble polymer. In particular, the epoxy group of the silane coupling agent and a hydrolysate thereof and the hydroxyl group of the polyvinyl alcohol interact with each other to enhance adhesion between the overcoat layer 30 and the gas barrier layer 20.

The total content of the silane coupling agent and a hydrolysate thereof or at least one reaction product thereof in the organic-inorganic composite film can be 1 to 15 mass%, for example. It is preferable that the total content of the silane coupling agent and a hydrolysate thereof or at least one reaction product thereof is 2 to 12 mass% because gas barrier properties of the organic-inorganic composite film can be further enhanced.

The thickness of the overcoat layer 30 can be determined according to the gas barrier properties required, and may be 0.05 to 5 μm, for example. The thickness of the overcoat layer 30 is preferably 0.05 μm to 1 μm, and more preferably 0.1 μm to 0.5 μm. If the thickness of the overcoat layer 30 is 0.05 μm or more, sufficient oxygen barrier properties can be easily achieved. If the thickness of the overcoat layer 30 is 1 μm or less, a uniform coating surface can be easily formed, and drying load and manufacturing cost can be reduced.

The gas barrier film having the above-described organic-inorganic composite film as an overcoat layer 30 maintains excellent gas barrier properties even when subjected to boiling treatment or retort sterilization treatment.

The gas barrier films according to the embodiments described above may be further provided with an undercoat layer 15, for example, between the substrate layer 10 and the gas barrier layer 20 as in the modification shown in Fig. 4. Specifically, Fig. 4 shows a gas barrier film 2A according to a modification of the second embodiment; however, the same modification may be made in the first embodiment shown in Fig. 1. Alternatively, the combination of the undercoat layer 15 and the gas barrier layer 20 may be provided to each of both surfaces of the substrate layer 10.

With the undercoat layer 15 provided on the substrate layer 10, adhesion between the substrate layer 10 and the gas barrier layer 20 can be enhanced, peeling of the gas barrier layer 20 can be prevented, and protection can be given against physical damage such as scratches and abrasions. The material for forming the undercoat layer 15 is not particularly limited, but thermosetting resins, thermoplastic resins, UV curable resins, electron beam curable resins, etc. can be used.

The thermosetting resins for forming the undercoat layer 15 include thermosetting urethane resins composed of an acrylic polyol resin and an isocyanate prepolymer, phenol resins, urea melamine resins, epoxy resins, unsaturated polyester resins, and silicone resins. Of these resins, adhesion between the substrate layer 10 and the gas barrier layer 20 can be enhanced in particular by forming the undercoat layer 15 using a composite of an acrylic polyol resin containing a hydroxyl group and/or an organic acid group and an isocyanate-based compound having at least two NCO groups in the molecule.

The acrylic polyol resin is a polymer compound obtained by polymerizing a (meth)acrylic acid derivative monomer or a polymer compound obtained by copolymerizing a (meth)acrylic acid derivative monomer with other monomers, or other polymer compounds, which has hydroxyl groups at the terminal and side chain and reacts with the NCO groups of an isocyanate-based compound. The (meth)acrylic acid derivative monomer has hydroxyl groups at the terminal and side chain, and examples of the (meth)acrylic acid derivative monomer include hydroxyethyl (meth)acrylate and hydroxybutyl (meth)acrylate.

The above other monomers are copolymerizable with a (meth)acrylic acid derivative monomer having hydroxyl groups at the terminal and side chain. Examples of the above other monomers may include (meth)acrylic acid derivative monomers having an alkyl group on the side chain, such as methyl (meth)acrylate, ethyl (meth)acrylate, n-butyl (meth) acrylate, and t-butyl (meth)acrylate; (meth)acrylic acid derivative monomers having a carboxyl group on the side chain, such as (meth)acrylic acid; and (meth)acrylic acid derivative monomers having an aromatic ring or cyclic structure on the side chain, such as benzyl (meth)acrylate and cyclohexyl (meth)acrylate. Examples other than (meth)acrylic acid derivative monomers may include styrene monomers, cyclohexylmaleimide monomers, and phenylmaleimide monomers. The above other monomers may themselves have hydroxyl groups at the terminal and side chain.

The acrylic polyol resin is particularly preferred to be a polymer compound obtained by polymerizing a (meth) acrylic acid derivative monomer having a carboxyl group on the side chain of (meth)acrylic acid, etc. The undercoat layer 15 may be formed using a composite of an acrylic polyol resin obtained by polymerizing a monomer having a carboxyl group and an isocyanate-based compound so that a gas barrier laminate film having higher water vapor barrier properties can be obtained.

The acrylic polyol resin having hydroxyl groups that can be used for forming the undercoat layer 15 is not

particularly limited, but it is preferable that the hydroxyl group value is 50 mg KOH/g or more and 250 mg KOH/g or less. The hydroxyl group value (mg KOH/g) refers to an index for a hydroxyl group content in an acrylic polyol resin, and refers to the quantity in mg of potassium hydroxide required to acetylate the hydroxyl groups in 1 g of an acrylic polyol resin. The weight average molecular weight of the acrylic polyol resin is not particularly limited, but is preferably 3,000 or more and 200,000 or less. It is more preferable that the weight average molecular weight is 5,000 or more and 100,000 or less. It is even more preferable that the weight average molecular weight is 5,000 or more and 40,000 or less.

The isocyanate-based compound used has two or more NCO groups in a molecule. Examples of monomer-based isocyanates include aromatic isocyanates such as tolylene diisocyanate (TDI), diphenylmethane diisocyanate (MDI), xylene diisocyanate (XDI), and tetramethylxylylene diisocyanate (TMXDI); and aliphatic isocyanates such as hexamethylene diisocyanate (HDI), bisisocyanate methylcyclohexane (H6XDI), isophorone diisocyanate (IPDI), and dicyclohexylmethane diisocyanate (H12MDI). Polymers or derivatives of these monomer-based isocyanates can also be used. For example, a trimer nurate type, adduct type reacted with 1,1,1-trimethylolpropane, etc., biuret type reacted with biuret, or other types can be used.

The isocyanate-based compound may be optionally selected from the above isocyanate-based compounds, or polymers or derivatives thereof, and may be used singly or in combination of two or more.

An example undercoat layer 15 may be formed by applying a solution composed of a composite of the above acrylic polyol resin and the above isocyanate-based compound and a solvent onto the substrate layer 10, and reaction-curing the coating. The equivalent ratio (NCO/OH) of the NCO groups of the isocyanate compound to the hydroxyl groups of the acrylic polyol resin is preferably 0.3 or more and 2.5 or less. The solvent used in this case may be any solvent that can dissolve the above acrylic polyol resin and the isocyanate-based compound. Examples of the solvent include methyl acetate, ethyl acetate, butyl acetate, cyclohexanone, acetone, methyl ethyl ketone, dioxolane, and tetrahydrofuran. Practically, these solvents can be used singly or in combination of two or more.

The thermoplastic resins for forming the undercoat layer 15 can be appropriately selected, for example, from polyols having two or more hydroxyl groups such as acrylic polyol, polyester polyol, polycarbonate polyol, polyether polyol, polycaprolactone polyol, and epoxy polyol; polyvinyl resins such as polyvinyl acetate and polyvinyl chloride; polyvinylidene chloride resins; polystyrene resins; polyethylene resins; polypropylene resins; polyurethane resins; and other resins. These resins may be mixed in any ratio. The hydroxyl group value of the polyols is not particularly limited but is preferably 10 mg KOH/g or more and 250 mg KOH/g or less.

The UV curable resins or electron beam curable resins for forming the undercoat layer 15 are not particularly limited as organic polymer resins, but desirably contain at least a resin having a hydroxyl group value in the range of 10 mg KHO/g or more and 100 mg KHO/g or less. Although not particularly limited as organic polymer resins, it is desirable to contain at least a resin having an acid value in the range of 10 mg KOH/g or more and 100 mg KOH/g or less. The acid value (mg KOH/g) refers to the quantity in mg of potassium hydroxide required to neutralize free fatty acids, resin acids, etc. contained in 1 g of a sample. It is desirable that at least a thermoplastic resin is contained as an organic polymer resin. If the hydroxyl group value or the acid value is less than 10 mg KOH/g, the chemical bonding strength between the functional group and the surface of the gas barrier layer 20 weakens, tending to deteriorate adhesion to the gas barrier layer 20. If the hydroxyl group value or the acid value exceeds 100 mg KOH/g, the hydroxyl group-containing precipitates, which are produced due to decomposition of the undercoat layer 15 in a durability test such as a humidity and heat resistance test, tend to hinder adhesion between the undercoat layer 15 and the gas barrier layer 20.

Examples of the monomer that can be used for the UV curable resin or electron beam curable resin for forming the undercoat layer 15 include monofunctional monomers such as ethyl(meth)acrylate, ethylhexyl(meth)acrylate, styrene, methylstyrene, and N-vinylpyrrolidone, and multifunctional monomers such as trimethylolpropane (meth)acrylate, hexanediol (meth)acrylate, tripropylene glycol di(meth)acrylate, diethylene glycol (meth)acrylate, pentaerythritol tri(meth)acrylate, dipentaerythritol hexa(meth)acrylate, 1,6-hexandiol di(meth)acrylate, and neopentylglycol (meth)acrylate. Oligomers that can be used for the UV curable resin or electron beam curable resin include urethane acrylate, epoxy acrylate, polyester acrylate, and the like.

When using two or more resins in combination selected from thermosetting resins, thermoplastic resins, UV curable resins, and electron beam curable resins as the organic polymer resins for forming the undercoat layer 15, the formulation ratio is not particularly limited.

The undercoat layer 15 may further contain additives as necessary in addition to the organic polymer resin. Examples of the additives include antioxidants, weather-resistant agents, heat stabilizers, lubricants, nucleating agents, UV absorbers, plasticizers, antistatic agents, colorants, fillers, surfactants, and silane coupling agents.

The thickness of the undercoat layer 15 is preferably 0.05 μm or more and 10.0 μm or less. It is particularly preferable that the thickness is 0.05 μm or more and 5.0 μm or less. If the thickness is less than 0.05 μm, adhesion between the substrate layer 10 and the gas barrier layer 20 becomes insufficient. If the thickness is greater than 10.0 μm, the influence of internal stress increases, the gas barrier layer 20 is not neatly laminated, barrier properties are not fully exhibited, and transparency and coating precision become insufficient.

A generally used coating method may be used as a method of forming the undercoat layer 15. For example, a

known method such as dipping, roll coating, gravure coating, reverse coating, air knife coating, comma coating, die coating, screen printing, spray coating, gravure offset printing, or organic vapor deposition may be used. Drying methods of applying heat, such as hot air drying, hot roll drying, high frequency irradiation, infrared irradiation, UV irradiation, and electron beam irradiation, may be used singly or in combination of two or more. In the forming method described above, a film applied in advance to a separate resin substrate may be transferred to the substrate layer 10 using a transfer method such as adhesive transfer, heat transfer, or UV transfer.

The gas barrier films according to the embodiments of the present invention will be further described using the examples and comparative examples. The technical scope of the present invention should not be limited solely on the basis of the specific contents of the examples and comparative examples.

(Example 1)

A biaxially stretched polypropylene film having a thickness of 20 μm was used as a substrate layer. Both of the Meissner coils (cooling temperature: both -120°C) installed in the deposition chamber and near the unwinding roll in the unwinding/winding chamber were used, so that the partial pressure at m/z 18 in the deposition chamber measured with a partial pressure meter during deposition was adjusted to 0.02 Pa. In the deposition chamber, an SiOx deposition material with an appropriately adjusted ratio between an Si material and an $SiO_2$ material was sublimated, and a gas barrier layer (thickness: 40 nm, O/Si: 1.7) made of silicon oxide (SiOx) was formed on the substrate layer by electron beam deposition.

Thus, a gas barrier film of Example 1 was prepared.

(Example 2)

A gas barrier film of Example 2 was prepared as in Example 1 except that the partial pressure at m/z 18 was adjusted to 0.01 Pa, and O/Si of the gas barrier layer was set to 1.3 by appropriately adjusting the ratio between the Si material and the $SiO_2$ material.

(Example 3)

A gas barrier film of Example 3 was prepared as in Example 1 except that the partial pressure at m/z 18 was adjusted to 0.04 Pa, and O/Si of the gas barrier layer was set to 1.8 by appropriately adjusting the ratio between the Si material and the $SiO_2$ material.

(Example 4)

A gas barrier film of Example 4 was prepared as in Example 1 except that the partial pressure at m/z 18 was adjusted to 0.01 Pa.

(Example 5)

A gas barrier film of Example 5 was prepared as in Example 1 except that the partial pressure at m/z 18 was adjusted to 0.04 Pa.

(Example 6)

A gas barrier film of Example 6 was prepared as in Example 1 except that the thickness of the gas barrier layer was adjusted to 10 nm.

(Example 7)

A gas barrier film of Example 7 was prepared as in Example 1 except that the thickness of the gas barrier layer was adjusted to 120 nm.

(Example 8)

A coating agent obtained by mixing the following Solutions (1) and (2) at a weight ratio of 6:4 was applied to the gas barrier layer of the gas barrier film of Example 1 by gravure coating, followed by drying to form an overcoat layer having a thickness of 0.4 μm.

Solution (1): Hydrolyzed solution with a solid content of 3 wt% ($SiO_2$ equivalent) obtained by adding 89.6 g of hydrochloric acid (0.1 N) to 10.4 g of tetraethoxysilane and stirring the mixture for 30 minutes for hydrolysis
Solution (2): 3 wt% polyvinyl alcohol solution / isopropyl alcohol solution (water:isopropyl alcohol (weight ratio) 90:10)

Thus, a gas barrier film of Example 8 was prepared.

(Example 9)

A coating agent with a solid content of 5 wt% obtained by mixing a polyvinyl alcohol solution, a hydrolyzed solution of tetraethoxysilane, and a hydrolyzed solution of 1,3,5-tris(3-trimethoxysilylpropyl)isocyanurate silane coupling agent so as to have a dry solids weight ratio of 30:60:10 was applied to the gas barrier layer of the gas barrier film of Example 1 by gravure coating, followed by drying to form an overcoat layer having a thickness of 0.4 μm.

Thus, a gas barrier film of Example 9 was prepared.

(Example 10)

A mixed solution of acrylic polyol and isocyanate was applied to the substrate layer by gravure coating, followed by drying to form an undercoat layer having a thickness of 0.2 μm. A gas barrier film of Example 10 was prepared by forming a gas barrier layer 20 on the undercoat layer as in Example 1.

(Comparative Example 1)

A gas barrier film of Comparative Example 1 was prepared as in Example 1 except that neither of the Meissner coils installed in the deposition chamber and the unwinding/winding chamber was used, the partial pressure of m/z 18 in the deposition chamber measured using a partial pressure meter during deposition was set to 0.10 Pa, and O/Si in the gas barrier layer was set to 1.9 by appropriately adjusting the ratio of the Si material to the $SiO_2$ material.

(Comparative Example 2)

A gas barrier film of Comparative Example 2 was prepared as in Example 1 except that the partial pressure at m/z 18 was adjusted to 0.04 Pa, and only the $SiO_2$ material was used as the SiOx material without mixing the Si material. O/Si in the gas barrier layer of Comparative Example 2 was 2.0.

(Comparative Example 3)

A gas barrier film of Comparative Example 3 was prepared as in Example 1 except that neither of the Meissner coils installed in the deposition chamber and the unwinding/winding chamber was used, and the partial pressure at m/z 18 in the deposition chamber measured using a partial pressure meter during deposition was set to 0.10 Pa.

(Comparative Example 4)

A gas barrier film of Comparative Example 4 was prepared as in Example 1 except that only the Meissner coil installed in the deposition chamber was used, and the partial pressure at m/z 18 in the deposition chamber measured using a partial pressure meter during deposition was set to 0.07 Pa.

The laminates related to the examples and comparative examples were evaluated as follows. Evaluation was performed on three samples for each of the examples and comparative examples.

(FT-IR analysis)

FT-IR analysis was performed using a Fourier transform infrared spectrophotometer (FT/IR-4600) manufactured by JASCO Corporation under the following measurement conditions.

Measurement method: Reflection ATR method (measured from gas barrier layer side of barrier film)

Measurement atmosphere: Air
Measurement temperature: Room temperature
ATR crystal: Germanium (wavenumber range 600 to 5,500 $cm^{-1}$)
Resolution: 4.0 $cm^{-1}$
Number of integrations: 64

In the infrared absorption spectrum obtained by FT-IR analysis, using software attached to the device, a baseline connecting the plots at both ends of a defined range was drawn for each of the peak area derived from the Si-O-Si bond (720 to 1,320 $cm^{-1}$), the peak area derived from the OH bond (3,100 to 3,700 $cm^{-1}$), the peak area derived from the Si-OH bond (830 to 910 $cm^{-1}$), and the peak area derived from the Si-H bond (2,100 to 2,200 $cm^{-1}$), and the area enclosed by the spectrum and the baseline was calculated. The region below the baseline was ignored and not included in the area. Measurement according to the ATR method was used in the FT-IR analysis; however, the area ratios shown below are based on data before correction without including corrections such as ATR correction and baseline correction.

(XPS analysis of gas barrier layer)

The composition ratio and bonding state of the inorganic oxide film as a gas barrier layer were measured using an X-ray photoelectron spectrometer (JPS-9010MX) manufactured by JEOL Ltd. The X-ray source used was Mg Kα, and the pass energy was set to 5 eV. The $Si_{2p}$ narrow spectrum was measured in the range of 95 to 106 eV, the $O_{1s}$ narrow spectrum in the range of 525 to 538 eV, and the $C_{1s}$ narrow spectrum in the range of 278 to 290 eV. To avoid the influence of noise, each narrow spectrum was repeatedly scanned and integrated 30 times or more. In this case, in order to avoid changes in chemical bonding state in the silicon oxide film due to reduction, mixing, etc. as a result of collision between argon (Ar) ions, the composition on the outermost surface was measured without performing argon etching. Since a peak shift occurred due to charging, correction was performed so that the $C_{1s}$ peak detected due to surface-contaminating hydrocarbons would be 284.6 eV.

(Evaluation on water vapor barrier properties)

For the gas barrier films of the examples and comparative examples, water vapor permeability (WVTR) was evaluated using a water vapor permeability measuring device (product name: PERMATRAN3/34G, measurement conditions: 40°C-90%RH, unit: g/($m^2$·day)) manufactured by Mocon, Inc.

The results are shown in Table 1.

[Table 1]

| | | Partial pressure at m/z 18 [Pa] | Sur. XPS evaluation results for transp. inorg. oxide film layer | | Evaluation results (Lot. 1) | | | | Evaluation results (Lot. 2) | | | | Evaluation results (Lot. 3) | | | | Standard deviation of water vapor permeability |
|---|---|---|---|---|---|---|---|---|---|---|---|---|---|---|---|---|---|
| | | | Compo. of transp. inorg. oxide film | peak ratio of $Si_{2p}$ | Infrared absorption peak area ratio of transparent inorganic oxide film | | | Water vapor perm. [g/$m^2$·day] | Infrared absorption peak area ratio of transparent inorganic oxide film | | | Water vapor perm. [g/$m^2$·day] | Infrared absorption peak area ratio of transparent inorganic oxide film | | | Water vapor perm. [g/$m^2$·day] | |
| | | | O/Si | b/a | OH/Si-O-Si | Si-OH/Si-O-Si | Si-H/Si-O-Si | | OH/Si-O-Si | Si-OH/Si-O-Si | Si-H/Si-O-Si | | OH/Si-O-Si | Si-OH/Si-O-Si | Si-H/Si-O-Si | | |
| Ex. | 1 | 0.02 | 1.7 | 0.133 | 0.10 | 0.008 | 0.0015 | 0.6 | 0.08 | 0.007 | 0.0013 | 0.5 | 0.12 | 0.010 | 0.0017 | 0.7 | 0.1 |
| | 2 | 0.01 | 1.3 | 0.152 | 0.07 | 0.006 | 0.0013 | 0.5 | 0.06 | 0.006 | 0.0011 | 0.4 | 0.09 | 0.008 | 0.0014 | 0.6 | 0.1 |
| | 3 | 0.04 | 1.8 | 0.126 | 0.18 | 0.015 | 0.0021 | 0.8 | 0.17 | 0.013 | 0.0019 | 0.7 | 0.19 | 0.016 | 0.0023 | 0.9 | 0.1 |
| | 4 | 0.01 | 1.7 | 0.141 | 0.08 | 0.007 | 0.0014 | 0.6 | 0.06 | 0.006 | 0.0012 | 0.5 | 0.10 | 0.008 | 0.0016 | 0.7 | 0.1 |
| | 5 | 0.04 | 1.7 | 0.128 | 0.17 | 0.013 | 0.0020 | 0.7 | 0.15 | 0.011 | 0.0017 | 0.6 | 0.18 | 0.015 | 0.0022 | 0.8 | 0.1 |
| | 6 | 0.02 | 1.7 | 0.133 | 0.10 | 0.008 | 0.0015 | 2.4 | 0.08 | 0.007 | 0.0013 | 2.1 | 0.12 | 0.010 | 0.0017 | 2.7 | 0.3 |
| | 7 | 0.02 | 1.7 | 0.133 | 0.10 | 0.008 | 0.0015 | 0.2 | 0.08 | 0.007 | 0.0013 | 0.1 | 0.12 | 0.010 | 0.0017 | 0.3 | 0.1 |
| | 8 | 0.02 | 1.7 | 0.132 | 0.10 | 0.008 | 0.0015 | 0.4 | 0.08 | 0.007 | 0.0013 | 0.3 | 0.12 | 0.010 | 0.0017 | 0.5 | 0.1 |
| | 9 | 0.02 | 1.7 | 0.135 | 0.10 | 0.008 | 0.0015 | 0.4 | 0.08 | 0.007 | 0.0013 | 0.3 | 0.12 | 0.010 | 0.0017 | 0.5 | 0.1 |
| | 10 | 0.02 | 1.7 | 0.133 | 0.15 | 0.004 | 0.0005 | 0.3 | 0.13 | 0.002 | 0.0003 | 0.2 | 0.20 | 0.008 | 0.0012 | 0.4 | 0.1 |
| Comp. Ex. | 1 | 0.10 | 1.9 | 0.112 | 0.33 | 0.028 | 0.0036 | 5.3 | 0.30 | 0.028 | 0.0035 | 4.8 | 0.34 | 0.030 | 0.0037 | 6.0 | 0.6 |
| | 2 | 0.04 | 2.0 | 0.100 | 0.35 | 0.030 | 0.0038 | 6.2 | 0.31 | 0.029 | 0.0036 | 5.6 | 0.38 | 0.033 | 0.0041 | 6.9 | 0.7 |
| | 3 | 0.10 | 1.7 | 0.115 | 0.32 | 0.028 | 0.0034 | 4.2 | 0.28 | 0.027 | 0.0033 | 3.3 | 0.34 | 0.030 | 0.0035 | 4.8 | 0.8 |
| | 4 | 0.07 | 1.7 | 0.121 | 0.30 | 0.027 | 0.0033 | 2.7 | 0.27 | 0.026 | 0.0032 | 1.4 | 0.22 | 0.017 | 0.0027 | 0.9 | 0.9 |

In all of the gas barrier films of the examples, as a result of calculation using FT-IR for the gas barrier layer 20, the ratio of the peak area of the absorption peak at 3,100 $cm^{-1}$ or more and 3,700 $cm^{-1}$ or less derived from the OH bond to the peak area of the absorption peak at 720 $cm^{-1}$ or more and 1,320 $cm^{-1}$ or less derived from the Si-O-Si bond was 0.25 or less, the ratio of the peak area of the absorption peak at 830 $cm^{-1}$ or more and 910 $cm^{-1}$ or less derived from the Si-OH bond to the peak area of the absorption peak at 720 $cm^{-1}$ or more and 1,320 $cm^{-1}$ or less derived from the Si-O-Si bond was 0.025 or less, and the ratio of the peak area of the absorption peak at 2,100 $cm^{-1}$ or more and 2,200 $cm^{-1}$ or less derived from the Si-H bond to the peak area of the absorption peak at 720 $cm^{-1}$ or more and 1,320 $cm^{-1}$ or less derived from the Si-O-Si bond was 0.003 or less.

Variations in WVTR in the examples were all within ±0.5 g (standard deviation: 0.5 g or less), and were stable.

On the other hand, in Comparative Examples 1 to 3 and Lots 1 and 2 of Comparative Example 4, as a result of

calculation using FT-IR for the gas barrier layer 20, the ratio of the peak area of the absorption peak at 3,100 $cm^{-1}$ or more and 3,700 $cm^{-1}$ or less derived from the OH bond to the peak area of the absorption peak at 720 $cm^{-1}$ or more and 1,320 $cm^{-1}$ or less derived from the Si-O-Si bond exceeded 0.25, the ratio of the peak area of the absorption peak at 830 $cm^{-1}$ or more and 910 $cm^{-1}$ or less derived from the Si-OH bond to the peak area of the absorption peak at 720 $cm^{-1}$ or more and 1,320 $cm^{-1}$ or less derived from the Si-O-Si bond was exceeded 0.025, and the ratio of the peak area of the absorption peak at 2,100 $cm^{-1}$ or more and 2,200 $cm^{-1}$ or less derived from the Si-H bond to the peak area of the absorption peak at 720 $cm^{-1}$ or more and 1,320 $cm^{-1}$ or less derived from the Si-O-Si bond exceeded 0.003.

Variations in WVTR in Comparative Examples 1 to 4 all exceeded $\pm$0.5 g (exceeded standard deviation of 0.5 g), and the quality was unstable. In Lot 3 of Comparative Example 4 in only which WVTR was less than 1.0 g ($m^2 \cdot$day), as a result of calculation using FT-IR for the gas barrier layer 20, the ratio of the peak area of the absorption peak at 3,100 $cm^{-1}$ or more and 3,700 $cm^{-1}$ or less derived from the OH bond to the peak area of the absorption peak at 720 $cm^{-1}$ or more and 1,320 $cm^{-1}$ or less derived from the Si-O-Si bond was 0.25 or less, the ratio of the peak area of the absorption peak at 830 $cm^{-1}$ or more and 910 $cm^{-1}$ or less derived from the Si-OH bond to the peak area of the absorption peak at 720 $cm^{-1}$ or more and 1,320 $cm^{-1}$ or less derived from the Si-O-Si bond was 0.025 or less, and the ratio of the peak area of the absorption peak at 2,100 $cm^{-1}$ or more and 2,200 $cm^{-1}$ or less derived from the Si-H bond to the peak area of the absorption peak at 720 $cm^{-1}$ or more and 1,320 $cm^{-1}$ or less derived from the Si-O-Si bond was 0.003 or less. This indicates that these three parameters are useful for evaluating the performance of the transparent inorganic oxide films, and that they can provide information that cannot be obtained from O/Si alone.

The results of the examples and comparative examples indicate that the gas barrier film of the present embodiment can be stably produced by forming a gas barrier layer on the substrate layer passing through the deposition chamber using a deposition material obtained by mixing the Si material and the $SiO_2$ material in a state in which the partial pressure at m/z 18 in the deposition chamber is set to 0.05 Pa or less using a gas adsorption device.

Compared to Comparative Example 4 prepared without using the gas adsorption device of the unwinding/winding chamber, the gas barrier film of Example 1 is considered to be superior in water vapor barrier properties to the deposition film initially formed on the substrate layer as a result of using the gas adsorption device of the unwinding/winding chamber. Thus, water vapor barrier properties stable throughout the gas barrier layer can be achieved. In particular, even when the thickness of the gas barrier layer is 40 nm as in Example 1, it is clear that suitable water vapor barrier properties can be achieved by improving the water vapor barrier properties of the initially formed deposition film.

Some embodiments of the present invention and examples have so far been described; however, specific configurations are not limited to these embodiments. The present invention should encompass modifications, combinations, or the like in the range not departing from the spirit of the present invention.

[Reference Signs List]

| | |
|---|---|
| 1, 2, 2A | Gas barrier film |
| 10 | Substrate layer |
| 15 | Undercoat layer |
| 20 | Gas barrier layer |
| 30 | Overcoat layer |
| 40 | Deposition chamber |
| 41 | Plastic film |
| 42 | Unwinding roll |
| 43 | Deposition roll |
| 44 | Winding roll |
| 45 | Vapor deposition material |
| 46 | Electron beam gun |
| 47 | Deposition particles |
| 48, 49 | Gas adsorption device |
| 50 | Unwinding/winding chamber |
| 100 | Deposition device |

## Claims

**1.** A gas barrier film, comprising

a substrate layer; and

a gas barrier layer formed on the substrate layer and containing silicon oxide, wherein
in an infrared absorption spectrum from a surface side of the gas barrier layer, a ratio of a peak area of an absorption peak at 3,100 $cm^{-1}$ or more and 3,700 $cm^{-1}$ or less derived from an OH bond to a peak area of an absorption peak at 720 $cm^{-1}$ or more and 1,320 $cm^{-1}$ or less derived from an Si-O-Si bond is 0.25 or less.

**2.** The gas barrier film according to claim 1, wherein
in an infrared absorption spectrum from a surface side of the gas barrier layer, a ratio of a peak area of an absorption peak at 830 $cm^{-1}$ or more and 910 $cm^{-1}$ or less derived from an Si-OH bond to a peak area of an absorption peak at 720 $cm^{-1}$ or more and 1,320 $cm^{-1}$ or less derived from an Si-O-Si bond is 0.025 or less.

**3.** The gas barrier film according to claim 1 or 2, wherein
in an infrared absorption spectrum from a surface side of the gas barrier layer, a ratio of a peak area of an absorption peak at 2,100 $cm^{-1}$ or more and 2,200 $cm^{-1}$ or less derived from an Si-H bond to a peak area of an absorption peak at 720 $cm^{-1}$ or more and 1,320 $cm^{-1}$ or less derived from an Si-O-Si bond is 0.003 or less.

**4.** The gas barrier film according to claim 1, wherein
a ratio b/a of a sum of peaks of $Si^{3+}$, $Si^{2+}$, $Si^{+}$ and Si (b = $Si^{3+}$, $Si^{2+}$, $Si^{+}$ and Si) to a sum of all of peaks in an $Si_{2p}$ peak (a= $Si^{4+}$, $Si^{3+}$, $Si^{2+}$, $Si^{+}$ and Si) on the surface of the gas barrier layer as measured by X-ray photoelectron spectroscopy (XPS) is greater than 0.122.

**5.** The gas barrier film according to claim 1, wherein
a ratio O/Si between the number of oxygen (O) atoms and the number of silicon (Si) atoms on the surface of the gas barrier layer as measured by X-ray photoelectron spectroscopy (XPS) is 1.41 or more and 1.9 or less.

**6.** The gas barrier film according to claim 1, wherein
the gas barrier layer has a thickness of 10 nm or more and 60 nm or less.

**7.** The gas barrier film according to claim 1, further comprising
an overcoat layer formed on the gas barrier layer.

**8.** The gas barrier film according to claim 7, wherein
the overcoat layer contains a water-soluble polymer and at least one of a metal alkoxide, a hydrolysate of a metal alkoxide, a reaction product of a metal alkoxide, and a reaction product of a hydrolysate of a metal alkoxide.

**9.** The gas barrier film according to claim 7, wherein
the overcoat layer contains at least one of a silane coupling agent, a hydrolysate of a silane coupling agent, a reaction product of a silane coupling agent, and a reaction product of a hydrolysate of a silane coupling agent.

**10.** The gas barrier film according to claim 1, further comprising

an undercoat layer provided between the substrate layer and the gas barrier layer, wherein
the undercoat layer contains at least one of a thermosetting resin, a thermoplastic resin, a UV curable resin, and an electron beam curable resin.

**11.** The gas barrier film according to claim 1, further comprising

an undercoat layer provided between the substrate layer and the gas barrier layer, wherein
the undercoat layer is made of a cured product of a composition containing an acrylic polyol resin having an organic acid group and a polyisocyanate.

**12.** A production method for the gas barrier film according to claim 1, wherein

a deposition device is set that includes a deposition chamber and an unwinding/winding chamber with a gas adsorption device provided in each of the deposition chamber and the unwinding/winding chamber;
a substrate layer in a roll shape is attached to an unwinding roll disposed in the unwinding/winding chamber; and
a gas barrier layer is formed on the substrate layer passing through the deposition chamber under conditions in which a partial pressure at m/z 18 in the deposition chamber is set to 0.05 Pa or less by operating the gas adsorption devices in the deposition chamber and the unwinding/winding chamber, the gas barrier layer being

made of a deposition material obtained by mixing an Si material and an $SiO_2$ material.

FIG.1

1
20
10

FIG.2

100
44
42
49
41
50
43
46
47
40
48
45
48

FIG.3
2
30
20
10
FIG.4
2A
30
20
15
10

## INTERNATIONAL SEARCH REPORT

International application No. **PCT/JP2024/037206**

**A. CLASSIFICATION OF SUBJECT MATTER**

***B32B 9/00***(2006.01)i; ***C23C 14/10***(2006.01)i; ***C23C 14/24***(2006.01)i
FI: B32B9/00 A; C23C14/24 R; C23C14/10

According to International Patent Classification (IPC) or to both national classification and IPC

**B. FIELDS SEARCHED**

Minimum documentation searched (classification system followed by classification symbols)

B32B100-43/00; C23C14/00-14/58

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2011-194667 A (FUJIFILM CORPORATION) 06 October 2011 (2011-10-06) paragraphs [0001], [0016]-[0028], [0031]-[0073], examples, fig. 1(a), 1(b), 3 | 1-4, 6, 10<br>5, 7-12 |
| Y | JP 2022-34746 A (TOPPAN PRINTING CO., LTD.) 04 March 2022 (2022-03-04) claims 1, 6, paragraphs [0025]-[0063], [0073] | 5, 7-11 |
| Y | JP 8-224825 A (TOYO BOSEKI KABUSHIKI KAISHA) 03 September 1996 (1996-09-03) claim 1, paragraphs [0001], [0007]-[0008], [0013] | 12 |
| A | WO 2018/101084 A1 (SUMITOMO CHEMICAL COMPANY, LIMITED) 07 June 2018 (2018-06-07) entire text | 1-12 |
| A | WO 2021/176948 A1 (TOPPAN PRINTING CO., LTD.) 10 September 2021 (2021-09-10) entire text | 1-12 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **08 January 2025** | **21 January 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br>Telephone No. |

Form PCT/ISA/210 (second sheet) (July 2022)

INTERNATIONAL SEARCH REPORT

International application No.
PCT/JP2024/037206

C. DOCUMENTS CONSIDERED TO BE RELEVANT

| Category* | Citation of document, with indication, where appropriate, of the relevant passages | Relevant to claim No. |
|---|---|---|
| A | WO 2022/270490 A1 (TOPPAN PRINTING CO., LTD.) 29 December 2022 (2022-12-29) entire text | 1-12 |

Form PCT/ISA/210 (second sheet) (July 2022)

**INTERNATIONAL SEARCH REPORT**
**Information on patent family members**

International application No.
**PCT/JP2024/037206**

| Patent document cited in search report | Publication date (day/month/year) | Patent family member(s) | Publication date (day/month/year) |
|---|---|---|---|
| JP 2011-194667 A | 06 October 2011 | (Family: none) | |
| JP 2022-34746 A | 04 March 2022 | (Family: none) | |
| JP 8-224825 A | 03 September 1996 | (Family: none) | |
| WO 2018/101084 A1 | 07 June 2018 | CN 109963711 A<br>KR 10-2019-0091296 A | |
| WO 2021/176948 A1 | 10 September 2021 | US 2023/0087185 A1<br>whole document<br>EP 4101639 A1<br>CN 115175815 A | |
| WO 2022/270490 A1 | 29 December 2022 | US 2024/0149572 A1<br>whole document<br>EP 4360871 A1<br>CN 117500659 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2023180257 A
- JP S9010MX B